# EUROPEAN PATENT APPLICATION

(11) **EP 1 914 883 A2**
(43) Date of publication of application: **23.04.2008**
(21) Application number: 07117657.2
(22) Date of filing: 01.10.2007
(51) Int. Cl.: H03F 1/26, H03F 3/45

(54) **Analog signal transmission circuit**

(30) Priority: 03.10.2006 JP 2006271902
(71) Applicant: OMRON CORPORATION, Kyoto-shi, Kyoto 600-8530 (JP)
(72) Inventor: Hashimoto, Masashi c/o Omron Corporation, Shimogyo-ku Kyoto-shi Kyoto 600-8530 (JP)
(74) Representative: Brykman, Georges

(57) **Abstract**

An analog signal transmission circuit that can suppress contamination of random noise is to be provided. A sample hold circuit is constructed by a CMOS switch, a hold capacitor, an amplifier and a pre-charge circuit. The amplifier does not operate during a sampling period, and operates during only a hold period, so that power consumption can be reduced. During the sampling period, the potential of a channel portion beneath the gate of the first transistor connected to the first terminal of the hold capacitor is stabilized with the potential of a high-potential power supply by the pre-charge circuit.

## Description

### BACKGROUND OF THE INVENTION

### 1. Field of the Invention

The present invention relates to an analog signal transmission circuit, and particularly to a technique of reducing noises contaminated in a transmission path of analog signals.

### 2. Description of Related Art

An analog signal transmission circuit such as a sample hold circuit (hereinafter referred to as S/H circuit) or the like is used in an A/D converter for converting an analog signal to a digital signal, an image pickup device or the like. The S/H circuit is constructed as shown in JP-A-2002-74977 (Patent Document 1) and in Fig. 6, for example.

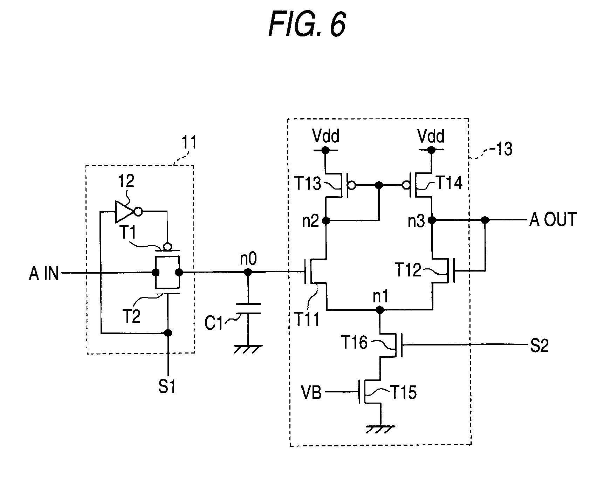

The S/H circuit shown in Fig. 6 turns on a CMOS switch 11 to accumulate charges corresponding to an input analog signal Ain into a hold capacitor C1, and outputs an output analog signal Aout corresponding the charge amount accumulated in the hold capacitor C1 from an amplifier 13. The amplifier 13 is a differential amplifying circuit, and it has a pair of first and second MOS transistors (hereinafter merely referred to as transistor) T11, T12, signals being input to the respective gates of the transistors, and third and fourth transistors T13 and T14 which are respectively connected between the first and second transistors T11 and T12 and a high-potential power supply line and also connected to each other in a current-mirror style. The amplifier 13 further has a fifth transistor T15 which is connected between the first and second transistors T11 and T12 and the ground and serves as a constant-current source. The gate of the first transistor T11 is connected to a hold capacitor C1, and an output analog signal Aout is fed back to the gate of the second transistor T12. The amplifier 13 outputs the output analog signal Aout having the potential corresponding to the input accumulated charge amount of the hold capacitor C1.

Furthermore, in the amplifier 13, a sixth transistor T16 serving as a switch is inserted and connected between the first and second transistors T11, T12 and the fifth transistor T15. The sixth transistor T16 is turned off during a sampling period of the input analog signal Ain, that is, while the CMOS switch 11 is turned on, and turned on during a period when the output analog signal Aout corresponding to the charges accumulated in the hold capacitor C1 is output. When the sixth transistor T16 is turned off, no current flows in the amplifier 13, and thus the power consumption in the amplifier 13 is reduced.

When the sixth transistor T16 is turned off, no current flows into the amplifier 13 and the potential of the channel portion beneath the gate of the first transistor T11 is unstable.

When the sixth transistor T16 is turned on and the amplifier 13 enters a normal operation state under the above state, the potential of the channel portion beneath the gate varies so that current I flows into the first transistor T11. At this time, the CMOS switch 11 is turned off, and thus the wire between the CMOS switch 11 and the first transistor T11 is set to a floating state, so that the potential V0 of the wire concerned (node n0), that is, the gate potential of the first transistor T11 is affected by the potential of the channel portion beneath the gate of the first transistor T11. As described above, the potential of the channel portion before turn-on is unstable, and thus when the sixth transistor T16 is turned on and thus current flows therein, the potential of the channel portion beneath the gate varies from the unstable potential to the potential corresponding to the voltage applied to the gate and the current flowing in the first transistor T11. The variation amount concerned cannot be uniquely determined. Therefore, there is a problem that the gate potential of the first transistor T11 varies randomly and thus random noise contaminates in the output analog output signal Aout.

### SUMMARY OF THE INVENTION

The present invention has an object to suppress contamination of random noise.

An analog signal transmission circuit according to the present invention that includes a sampling switch supplied with an analog signal, a capacitor connected between the output side terminal of the sampling switch and a low-potential power supply, and a differential amplifier connected to an output side terminal of the sampling switch, and samples the analog signal by turning on/off the sampling switch and outputs a signal achieved by amplifying in the differential amplifier an accumulation voltage of the capacitor which is achieved by the sampling, wherein the differential amplifier has a differential input portion comprising: a first transistor connected to a first terminal of the capacitor and a second transistor to which the output signal of the differential amplifier is input; a constant current source for making current flow in the differential input portion; and an actuating switch that is connected between the constant current source and the differential input portion and turned on/off by a control signal, and a pre-charge circuit for pre-charging a wire between the differential input portion and the actuating switch to a predetermined potential when the actuating switch is turned off.

According to the present invention, no current flows into the differential amplifier by turning off the actuating switch, and thus the current consumption in the differential amplifier is reduced. Furthermore, when the actuating switch is turned off, the wire between the differential input portion and the actuating switch in the differential amplifier is pre-charged to a predetermined potential by the pre-charge circuit. Accordingly, when the differential amplifier is not operated, the potential of the first transistor connected to the first terminal of the capacitor is stable, and thus contamination of random noise into the analog signal held in the capacitor can be suppressed.

In an embodiment of the present invention, the differential amplifier has a current mirror circuit comprising a pair of transistors connected between the differential input portion and the high-potential power supply, and the pre-charge circuit pre-charges to a predetermined potential at least one of the wire between the first transistor and the current mirror circuit and the wire between the second transistor and the current mirror circuit. According to this embodiment, in addition to the wire between the differential input portion and the actuating switch, at least one of the wire between the first transistor and the current mirror circuit and the wire between the second transistor and the current mirror circuit is pre-charged. Therefore, the potential of the first transistor is more stable as the case where only the wire between the differential input portion and the actuating switch is pre-charged to a predetermined potential, so that the contamination of random noise can be suppressed with higher precision.

In an embodiment of the present invention, the actuating switch is connected between the first transistor and the constant current source, and it is an MOS type transistor having the gate to which the control signal is input. The pre-charge circuit is connected between the wire and the wire for supplying a predetermined potential, and it is an MOS type transistor having the gate to which the control signal is input. According to this embodiment, the actuating switch and the pre-charge circuit can be controlled by one control signal. Furthermore, when the actuating switch is turned off, the pre-charge circuit can be surely set to a conduction state to pre-charge the wire.

In an embodiment of the present invention, the actuating switch is connected between the first transistor and the constant current source, and it is the MOS type transistor having the gate to which the control signal is input. The pre-charge circuit has an inverter circuit to which the control signal is input, and an MOS type transistor that has the gate connected to the output terminal of the inverter circuit and is connected between the wire and a wire for supplying a predetermined potential. In this embodiment, the actuating switch and the pre-charge circuit can be controlled by one control signal. Furthermore, when the actuating switch is turned off, the pre-charge circuit can be surely set to a conduction state to pre-charge the wire.

In an embodiment of the present invention, the predetermined potential is set to the level of the high-potential power supply. According to this embodiment, the potential of the transistor connected to the capacitor can be stabilized without supplying another power supply.

In an embodiment of the present invention, the actuating switch is turned on/off complementarily with the sampling switch. According to this embodiment, the actuating switch and the sampling switch are operated complementarily. Therefore, during the sampling period when the sampling switch is turned on, the actuating switch is turned off and no current flows into the differential amplifier, so that the current consumption in the differential amplifier is reduced. Furthermore, during the hold period when the sampling switch is turned off, the actuating switch is turned on and outputs an accumulated analog signal to the capacitor. Furthermore, the pre-charge circuit pre-charges a predetermined wire when the actuating switch is turned off, and it does not pre-charge when the actuating switch is turned on. That is, it pre-charges during the sampling period of the analog signal, and does not pre-charge during the hold period. Therefore, when the sampling period of the analog signal is changed to the hold period, the effect of the differential amplifier on the capacitor can be fixed, and thus the contamination of random noise into the analog signal held in the capacitor can be suppressed.

As described above, according to the present invention, the contamination of random noise into the analog signal can be suppressed with reducing the power consumption.

### BRIEF DESCRIPTION OF THE DRAWINGS

Fig. 1 is a circuit diagram showing an analog signal transmission circuit according to a first embodiment.
Fig. 2 is a block circuit diagram of a solid-state image pickup device.
Fig. 3 is a circuit diagram showing an analog signal transmission circuit according to a second embodiment.
Fig. 4 is a circuit diagram showing another analog signal transmission circuit according to the first embodiment.
Fig. 5 is a circuit diagram showing another analog signal transmission circuit according to the second embodiment.
Fig. 6 is a circuit diagram showing a related-art analog signal transmission circuit.

### DESCRIPTION OF PREFERRED EMBODIMENTS

### (First Embodiment)

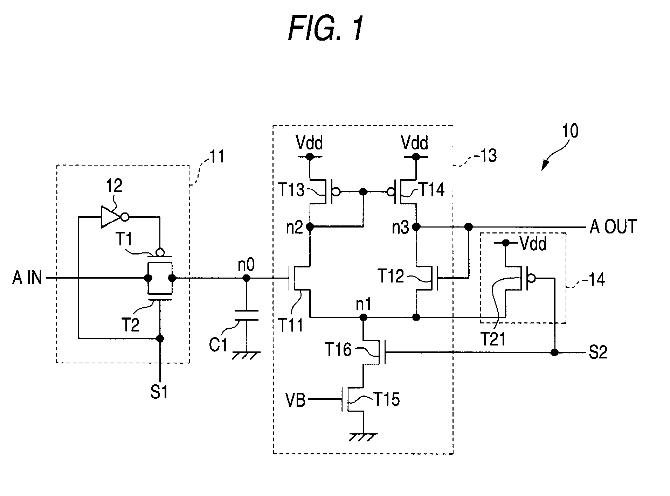

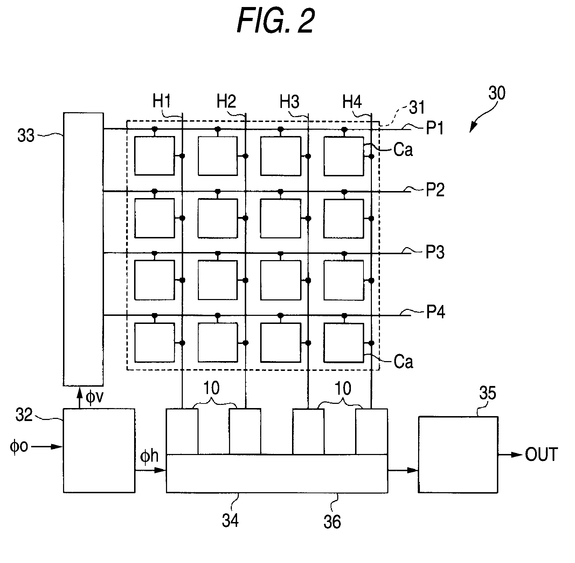

An embodiment achieved by embodying the present invention will be described with reference to Figs. 1 and 2.

As shown in Fig. 1, a sample hold circuit (hereinafter referred to as S/H circuit) 10 of this embodiment is constructed by a CMOS switch 11, a hold capacitor C1, an amplifier 13 and a pre-charge circuit 14. The CMOS switch 11 is constructed by a pair of P-channel MOS transistor T1 and N-channel MOS transistor T2 which are connected to each other in parallel, and an inverter circuit 12. A first control signal S1 is input to the gate of the N-channel MOS transistor T2 and the inverter circuit 12, and a control signal achieved by logically inverting the first control signal S1 is supplied to the gate of the P-channel MOS transistor T1 by the inverter circuit 12.

Accordingly, the CMOS switch 11 is turned on/off in response to the first control signal S1 . An input analog signal Ain is input to a first terminal (input side terminal) of the CMOS switch 11, and a second terminal (output side terminal) thereof is connected to an amplifier 13.

A first terminal of a hold capacitor C1 is connected to the wire (hereinafter referred to as node n0) between the CMOS switch 11 and the input terminal of the amplifier 13, and a second terminal thereof is connected to a low-potential power supply (the ground GND in this embodiment).

The amplifier 13 is constructed by a pair of first and second transistors T11 and T12 having gates to which signals are input, third and fourth transistors T13 and T14 which are connected to each other in a current mirror style, a fifth transistor T15 operating as a constant current source, and a sixth transistor T16 serving as a switch. The first and second transistors T11, T12 constitute a differential input portion, and the sixth transistor T16 constitutes a switch element.

The pair of first and second transistors T11, T12 are constructed by N-channel MOS transistors. The drains of the first and second transistors T11, T12 are connected to the drains of the third and fourth transistors T13 and T14, and the sources of the first and second transistors T11, T12 are connected to each other. The wire (hereinafter referred to as node n1) between the first and second transistors T11 and T12 is connected to the fifth transistor T15.

The third and fourth transistor T13 and T14 are constructed by P-channel MOS transistors. The sources of the third and fourth transistors T13 and T14 are connected to a high-potential power source Vdd, and the drains of the third and fourth transistors T13 and T14 are connected to the drains of the first and second transistors T11 and T12, respectively. The gate and drain of the third transistor T13 are connected to each other, and the gate of the third transistor T13 is connected to the gate of the fourth transistor T14. That is, the third transistor T13 and the fourth transistor T14 are connected to each other in a current-mirror style.

The fifth transistor T15 comprises an N-channel MOS transistor, the source of the fifth transistor T15 is connected to the ground, and the drain of the fifth transistor T15 is connected to the node n1. A bias voltage VB is supplied to the gate of the fifth transistor T15, and the fifth transistor T15 operates as a constant current source by the bias voltage VB.

The sixth transistor T16 is inserted and connected between the fifth transistor T15 and the node n1. The sixth transistor T16 comprises an N-channel MOS transistor, the source of the sixth transistor T16 is connected to the drain of the fifth transistor T15, and the drain of the sixth transistor T16 is connected to the node n1. A second control signal S2 is input to the gate of the sixth transistor T16, and the six transistor T16 is turned on/off in response to the second control signal S2. That is, the sixth transistor T16 operates as a switch.

The gate of the first transistor T11 is connected to the hold capacitor C1. An output analog signal Aout is output from the wire between the second transistor T12 and the fourth transistor T14 (hereinafter referred to as node n2). The output analog signal Aout is fed back to the gate of the second transistor T12.

A pre-charge circuit 14 is connected to the node n1 which is connected to the source of the first transistor T11. The pre-charge circuit 14 comprises a transistor T21. This transistor T21 comprises a P-channel MOS transistor, and the source of the transistor T21 is connected to the high-potential power supply Vdd, and the drain thereof is connected to the node n1. The second control signal S2 is input to the gate of the transistor T21, and the transistor T21 is turned on/off in response to the second control signal S2. Accordingly, the pre-charge circuit 14 connects or disconnects the node n1 and the high-potential power supply Vdd in response to the second control signal S2.

The second control signal S2 is also supplied to the gate of the sixth transistor T16 constituting the amplifier 13. The sixth transistor T16 constituting the amplifier 13 and the transistor T21 constituting the pre-charge circuit 14 comprise transistors which are different in conduction type. Accordingly, the sixth transistor T16 and the transistor T21 of the pre-charge circuit 14 are complementarily turned on/off in response to the second control signal S2.

As described above, by inputting the first control signal S1 and the second control signal S2, the sixth transistor T16 is turned off during the sampling period of the input analog signal Ain, that is, while the CMOS switch 11 is turned on, and it is turned on during the period when the output analog signal Aout corresponding to the charges accumulated in the hold capacitor C1 is output. The transistor T21 of the pre-charge circuit 14 operates complementarily with the sixth transistor T16. Therefore, it is turned on while the CMOS switch 11 is turned on, and it is turned off during the period when the output analog signal Aout corresponding to the charges accumulated in the hold capacitor C1 is output.

The operation of the thus-constructed S/H circuit 10 will be described.

The CMOS switch 11 constituting the S/H circuit 10 is turned on in response to the first control signal S1 of H level, and turned off in response to the first control signal S1 of L level. The charges corresponding to the input analog signal Ain when the CMOS switch 11 is turned on are accumulated in the hold capacitor C1 constituting the S/H circuit 10. When the CMOS switch 11 is turned off, the wire connected to the first terminal of the hold capacitor C1 falls into a floating state, and the charges accumulated in the hold capacitor C1 are held. Accordingly, the period when the CMOS switch 11 is turned on is the sampling period, and the period when the CMOS switch 11 is turned off is the hold period.

### [Sampling period]

During this period, the second control signal S2 of L level is supplied to the S/H circuit 10. The sixth transistor T16 of the amplifier 13 is turned off in response to the second control signal S2 of L level. Accordingly, no current flows in the amplifier 13, and the power consumption is reduced. The pre-charge circuit 14 connects the node n1 of the amplifier 13 to the high-potential power supply Vdd in response to the second control signal S2 of L level. Accordingly, the potential of the source of the first transistor T11 is stable, and thus the potential of the channel portion beneath the gate of the first transistor T11 is stable.

### [Hold period]

During this period, the second control signal S2 of H level is supplied to the S/H circuit 10. The pre-charge circuit 14 disconnects the node n1 of the amplifier 13 from the high-potential power supply Vdd in response to the second control signal S2 of H level. The sixth transistor T16 of the amplifier 13 is turned on in response to the second control signal S2 of H level. At this time, the potential of the node n1 is varied from the stable high-potential power supply Vdd level by the per-charge circuit 14. Accordingly, the potential of the channel portion beneath the gate of the first transistor T11 is varied from the stable fixed potential, and thus contamination of random noise can be suppressed.

### [Application example of S/H circuit]

The S/H circuit 10 is used in a solid-state image pickup device as shown in Fig. 2. The solid-state image pickup device 30 contains an image pickup portion 31, a control circuit 32, a vertical scanning circuit 33, a horizontal scanning circuit 34 and an output circuit 35, and the S/H circuit is contained in a horizontal scanning circuit 34.

The image pickup portion 31 has plural pixels Ca arranged in a matrix form. In order to simplify the description, the image pickup portion 31 having pixels Ca arranged in a matrix form of 4 lines x 4 columns will be described in this embodiment.

On the basis of a clock signal Φo, the control circuit 32 generates a vertical clock signal Φv as a selection signal for selecting a line of the image pickup portion 31, a horizontal clock signal Φh as a selection signal for selecting a column of the image pickup portion 31, and a control signal for driving the respective pixels Ca, etc.

The vertical scanning circuit 33 contains a shift resister in the vertical direction, and a voltage control circuit for controlling the voltage supplied to each pixel Ca, and four line signal lines P1 to P4 corresponding to the number of the lines of the image pickup portion 31 are connected to the vertical scanning circuit 33. The vertical scanning circuit 33 successively selects the line signal lines P1 to P4 on the basis of the vertical clock signal Φv, and supplies the driving signal of the voltage controlled by the voltage control circuit to the pixels Ca through the selected line signal line.

The horizontal scanning circuit 34 contains four S/H circuits 10 corresponding to the number of the columns of the image pickup portion 31 and a shift register 36. Four column signal lines H1 to H4 corresponding to the number of the columns of the image pickup portion 31 are connected to the respective S/H circuit 10. Each pixel Ca is connected to the cross point between each line signal line P1 to P4 and each column signal line H1 to H4.

The pixels Ca connected to the line signal lines P1 to P4 outputs the photoelectrically-converted signals to the column signal lines H1 to H4 in response to driving signals supplied through the line signal lines P1 to P4. The shift register 36 supplies the respective S/H circuits 10 with the first control signal S1 and the second control signal S2 on the basis of the horizontal clock signal Φh. The S/H circuits 10 connected to the respective column signal lines H1 to H4 sample the photoelectrically converted signals input through the column signal lines H1 to H4 and output both the sampling signals.

The shift register 36 transmits the signal output from each S/H circuit 10 to the output circuit 35 on the basis of the horizontal clock signal Φh, and the output circuit 35 generates and outputs an output signal out achieved by expanding the pulse width of the signal output from the horizontal scanning circuit 34.

As described above, according to this embodiment, the following effect can be achieved.
(1) The gate of the first transistor T11 constituting the amplifier 13 is connected to the hold capacitor C1 for holding the input analog signal Ain, and the pre-charge circuit 14 is connected to the node n1 connected to the source of the first transistor T11. Therefore, even in the sampling period when the potential in the amplifier 13 is unstable, the potential of the node n1 connected to the pre-charge circuit 14 is stable, and the potential of the channel portion beneath the gate of the first transistor T11 connected to the first terminal of the hold capacitor C1 is also stable. Accordingly, even if the potential in the amplifier 13 is varied when the sampling period is changed to the hold period, the potential of the channel portion beneath the gate of the first transistor T11 connected to the first terminal of the hold capacitor C1 is varied from the stable fixed potential, and thus contamination of random noise can be suppressed.
(2) The sixth transistor T16 and the transistor T21 of the pre-charge circuit 14 are complementarily operated on the basis of one second control signal S2, so that the node n1 can be surely pre-charged during the sampling period when no current flows into the amplifier 13.
(3) The potential to be pre-charged is the high-potential power supply Vdd, and thus the potential of the channel portion beneath the gate of the first transistor T11 connected to the first terminal of the hold capacitor C1 can be stabilized without supplying another power supply.

### (Second Embodiment)

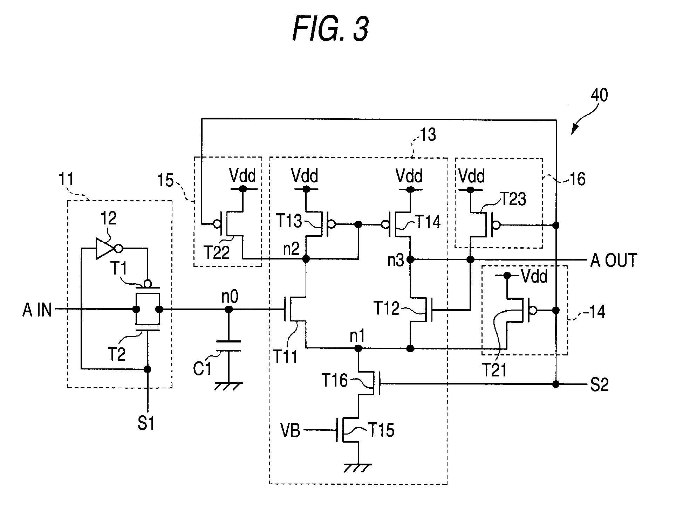

A second embodiment achieved by embodying the present invention will be described with reference to Fig. 3.

For the convenience of description, the same constituent elements as shown in Fig. 1 are represented by the same reference numerals and the descriptions thereof are partially omitted.

As shown in Fig. 3, the S/H circuit of this embodiment is equipped with pre-charge circuits 15, 16 in addition to the S/H circuit of the first embodiment.

The pre-charge circuit 15 is connected to a node n2 connected to the drain of the first transistor T11, and the pre-charge circuit 16 is connected to the wire (hereinafter referred to as node n3) connected to the drain of the second transistor T12. The pre-charge circuit 15 is constructed by a transistor T22, and the pre-charge circuit 16 is constructed by a transistor T23. Both the transistors T22 and T23 comprise P-channel MOS transistors. The sources of the transistor T22 of the pre-charge circuit 15 and the transistor T23 of the pre-charge circuit 16 are connected to the high-potential power supply Vdd, the drain of the transistor T22 of the pre-charge circuit 15 is connected to the node n2, and the drain of the transistor T23 of the pre-charge circuit 16 is connected to the node n3. The second control signal S2 is input to the gate of the transistor T22 of the pre-charge circuit 15 and the gate of the transistor T23 of the pre-charge circuit 16.

The transistor T22 of the pre-charge circuit 15 and the transistor T23 of the pre-charge circuit 16 are turned on/off in response to the second control signal S2. Accordingly, the pre-charge circuit 15 connects or disconnects the node n2 and the high-potential power supply Vdd in response to the second control signal S2, and the pre-charge circuit 16 connects or disconnects the node n3 and the high-potential power supply Vdd in response to the second control signal S2. The transistor T22 of the pre-charge circuit 15 and the transistor T23 of the pre-charge circuit 16 are transistors having the same conduction type as the transistor T21 of the pre-charge circuit 14. Accordingly, the pre-charge circuits 15, 16 operate in synchronism with the pre-charge circuit 14.

The operation of the S/H circuit 40 thus constructed will be described.

### [Sampling Period]

In this period, the S/H circuit 40 is supplied with the second control signal S2 of L level. The sixth transistor T16 of the amplifier 13 is turned off in response to the second control signal S2 of L level. Accordingly, no current flows into the amplifier 13, and thus the power consumption is reduced. The pre-charge circuit 14 connects the node n1 of the amplifier 13 to the high-potential power supply Vdd in response to the second control signal S2 of L level. Likewise, the pre-charge circuit 15 connects the node n2 to the high-potential power supply Vdd, and the pre-charge circuit 16 connects the node n3 to the high-potential power supply Vdd. Accordingly, the potential of the source and drain of the first transistor T11 is stable, and thus the potential of the channel portion beneath the gate of the first transistor T11 is also stable. At this time, since the node n3 is also connected to the high-potential power supply Vdd, the first to fourth transistors T11, T12, T13, T14 of the amplifier 13 are kept balanced in potential.

### [Hold Period]

In this period, the S/H circuit 40 is supplied with the second control signal S2 of H level. The pre-charge circuit 14 disconnects the node n1 of the amplifier 13 from the high-potential power supply Vdd in response to the second control signal S2 of H level. Likewise, the pre-charge circuit 15 disconnects the node n2 from the high-potential power supply Vdd, and the pre-charge circuit 16 disconnects the node n3 from the high-potential power supply Vdd. The sixth transistor T16 of the amplifier 13 is turned on in response to the second control signal S2 of H level. At this time, the potential of the node n1 is varied from the stable high-potential power supply Vdd level by the pre-charge circuit 14 and the pre-charge circuit 15. Accordingly, the potential of the channel portion beneath the gate of the first transistor T11 is varied from the stable fixed potential, and thus contamination of random noise can be suppressed.

As described above, according to this embodiment, the following effect can be achieved.
(1) In addition to the potential V1 of the node n1 stabilized in the first embodiment, the potential V2 of the node n2 and the potential V3 of the node n3 are stabilized. Therefore, the potential of the channel portion beneath the gate of the first transistor T11 connected to the first terminal of the hold capacitor C1 can be further stabilized with high precision while the power consumption of the amplifier 13 is reduced, so that contamination of random noise into the input analog signal Ain can be suppressed.

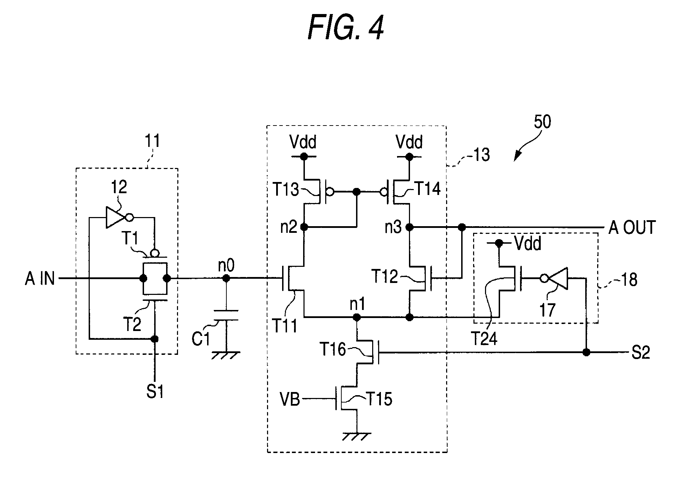

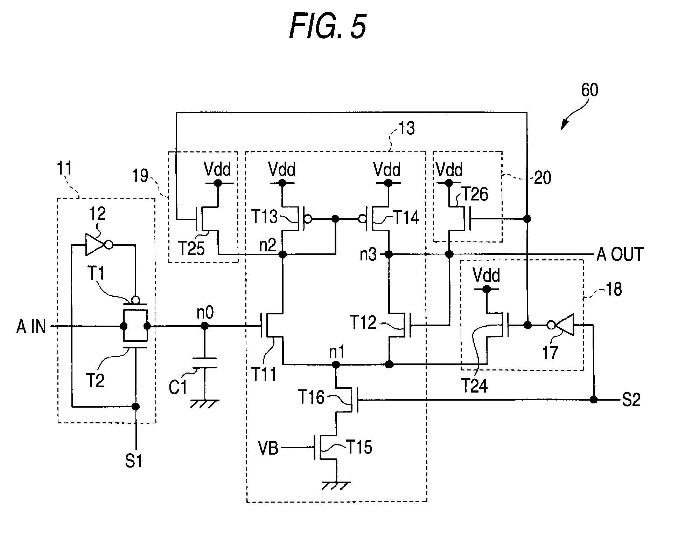

Each embodiment described above may be implemented according to the following mode.
• In the first embodiment, the pre-charge 14 comprising the P-channel MOS transistor may be constructed by a pre-charge circuit 18 comprising an N-channel MOS transistor and an inverter circuit. That is, as shown in Fig. 4, the pre-charge circuit 18 comprises a transistor T24 and an inverter circuit 17. The transistor T24 comprises an N-channel MOS transistor, the drain of the transistor T24 is connected to the high-potential power supply Vdd, the source thereof is connected to the node n1, and the second control signal S2 is input to the inverter circuit 17. The inverter circuit 17 supplies the gate of the transistor T24 with the control signal achieved by logically inverting the second control signal S2. Accordingly, the pre-charge circuit 18 carries out the same operation as the pre-charge circuit 14. Therefore, the power consumption of the amplifier 13 is reduced, and random noise which contaminates into the input analog signal Ain can be suppressed.
• In the second embodiment, the pre-charge circuits 14, 15 and 16 may be constructed by a pre-charge circuit 18 comprising an N-channel MOS transistor and an inverter circuit and pre-charge circuits 19, 20 comprising N-channel MOS transistors. That is, as shown in Fig. 5, the pre-charge circuit 18 is constructed by the transistor T24 and the inverter circuit 17, the pre-charge circuit 19 is constructed by a transistor T25, and the pre-charge circuit 20 is constructed by a transistor T26. The transistor T22, the transistor T25 and the transistor T26 of the respective pre-charge circuits comprise N-channel MOS transistors and the drain of each transistor is connected to the high-potential power supply Vdd. The source of the transistor T22 of the pre-charge circuit 18 is connected to the node n1, the source of the transistor T25 of the pre-charge circuit 19 is connected to the node n2, and the source of the transistor T26 of the pre-charge circuit 20 is connected to the node n3. Accordingly, the pre-charger circuits 18, 19, 20 carry out the same operations as the pre-charge circuits 14, 15, 16. Therefore, contamination of random noise into the input analog signal Ain can be suppressed with high precision while the power consumption of the amplifier 13 can be reduced.
• In each embodiment described above, the control signals for controlling the sixth transistor T16 and each pre-charge circuit are not required to be identical to each other, and they may be different from each other.
• In each embodiment described above, the potential to be stabilized in each pre-charge circuit is not limited to the high-potential power supply Vdd level, but it may be any potential, for example, a half level of the high-potential power supply Vdd level.
• An application example of the S/H circuit is not limited to the solid-state image pickup device, but it may be an A/D converter.

## Claims

1. An analog signal transmission circuit which comprises:
a sampling switch supplied with an analog signal,
a capacitor connected between the output side terminal of the sampling switch and a low-potential power supply, and
a differential amplifier connected to an output side terminal of the sampling switch, and
samples the analog signal by turning on/off the sampling switch and outputs a signal achieved by amplifying in the differential amplifier an accumulation voltage of the capacitor which is achieved by the sampling,
wherein the differential amplifier has a differential input portion comprising: a first transistor connected to a first terminal of the capacitor and a second transistor to which the output signal of the differential amplifier is input; a constant current source for making current flow in the differential input portion; and an actuating switch that is connected between the constant current source and the differential input portion and turned on/off by a control signal, and the analog signal transmission circuit is further provided with a pre-charge circuit for pre-charging a wire between the differential input portion and the actuating switch to a predetermined potential when the actuating switch is turned off.

2. The analog signal transmission signal according to claim 1, wherein the differential amplifier has a current mirror circuit comprising a pair of transistors connected between the differential input portion and the high-potential power supply, and the pre-charge circuit pre-charges to a predetermined potential at least one of the wire between the first transistor and the current mirror circuit and the wire between the second transistor and the current mirror circuit.

3. The analog signal transmission circuit according to claim 1 or 2, wherein the actuating switch is connected between the first transistor and the constant current source and comprises an MOS type transistor having the gate to which the control signal is input, and the pre-charge circuit is connected between the wire and the wire for supplying a predetermined potential and comprises an MOS type transistor having the gate to which the control signal is input.

4. The analog signal transmission circuit according to claim 1 or 2, wherein the actuating switch is connected between the first transistor and the constant current source and comprises an MOS type transistor having the gate to which the control signal is input, and the pre-charge circuit comprises an inverter circuit to which the control signal is input, and an MOS type transistor that has the gate connected to the output terminal of the inverter circuit and is connected between the wire and a wire for supplying a predetermined potential.

5. The analog signal transmission circuit according to any one of claims 1 to 4, wherein the predetermined potential is set to the level of the high-potential power supply.

6. The analog signal transmission circuit according to any one of claims 1 to 5, wherein the actuating switch is turned on/off complementarily with the sampling switch.
